# EUROPEAN PATENT SPECIFICATION

(11) **EP 2 032 506 B1**
(45) Date of publication and mention of the grant of the patent: **10.08.2016**
(21) Application number: 07874562.7
(22) Date of filing: 21.06.2007
(51) Int. Cl.: C01F 7/02, C08K 3/22, C09K 21/02, C09C 1/40, C09C 1/02, C08K 9/02, H05K 1/03

(54) **ALUMINUM HYDROXIDE**
ALUMINIUMHYDROXID
HYDROXYDE D'ALUMINIUM

(30) Priority: 21.06.2006 US 815426 P; 10.10.2006 US 828877 P; 10.10.2006 US 828912 P; 12.02.2007 US 889320 P; 12.02.2007 US 889316 P; 05.07.2006 US 818670 P; 27.02.2007 US 891745 P; 05.07.2006 US 818633 P; 07.05.2007 US 916477 P; 27.02.2007 US 891748 P; 10.10.2006 US 828901 P; 21.06.2006 US 815515 P; 12.02.2007 US 889327 P; 27.02.2007 US 891747 P; 05.07.2006 US 818632 P; 27.02.2007 US 891746 P; 12.02.2007 US 889330 P; 10.10.2006 US 828908 P; 12.02.2007 US 889325 P; 12.02.2007 US 889319 P
(43) Date of publication of application: 11.03.2009
(73) Proprietor: Martinswerk GmbH, 50127 Bergheim (DE)
(72) Inventor: HERBIET, Rene, Gabriel, Erich, B-4700 Eupen (BE); TOEDT, Winfried, 54597 Steffein-Auel (DE); KELLER, Volker Ernst Willi, 50226 Frechen (DE); PUETZ, Norbert, Wilhelm, 50129 Niederaubem (DE)
(74) Representative: Uexküll & Stolberg
(86) International application number: PCT/IB2007/004663
(87) International publication number: WO 2009/001169

(56) References cited:
- EP-A- 0 807 603
- GB-A- 1 317 527
- GB-A- 1 456 310
- JP-A- 10 059 713
- US-A- 3 950 507
- US-A- 4 989 794
- WILLY A. BACHOFEN AG MASCHINENFABRIK: 'DYNO-MILL KD; Horizontal agitator bead mill', [Online] Retrieved from the Internet: <URL:http://www.wab.ch/fileadmin/redaktion/ downloads/Prospekte_/EN_KD_Leaflet.pdf> [retrieved on 2011-02-11]

## Description

### FIELD OF THE INVENTION

The present invention relates to aluminum hydroxide flame retardants and their use

### BACKGROUND OF THE INVENTION

Aluminum hydroxide has a variety of alternative names such as aluminum hydrate, aluminum trihydrate etc., but is commonly referred to as ATH. ATH particles find use as a filler in many materials such as, for example, plastics, rubber, thermosets, papers, etc. These products find use in diverse commercial applications such as wire and cable compounds, conveyor belts, thermoplastics moldings, wall claddings, floorings, etc. ATH is typically used to improve the flame retardancy of such materials and also acts as a smoke suppressant.

Methods for the synthesis of ATH are well known in the art. For example, see EP 1 206 412 B1 describes the production of fine precipitated aluminum hydroxide grades wherein a pregnant liquor obtained from the Bayer process is seeded with bayerite crystals By using controlled conditions during crystallization, tailor made ATH grades with consistent product qualities can be produced The ATH grades are typically distinguished by two important characteristics, the median particle size, commonly referred to as d₅₀, and the specific surface, commonly referred to as the BET specific surface area, and these two characteristics are major criteria to select an ATH for a specific application.

EP 0 807 603 3 A2 describes the production of ATH with a BET specific surface area 2 of at least 30m²/g, a maximum pore size distribution of 300 nm and a mean particle size of 1.0 µm, which is used as a filler for rubber compositions from which tire treads are made.

However, ATH's are not selected solely on their d₅₀ and/or BET specific surface areas. To the contrary, ATH's are also selected based on the compounding performance of the ATH-containing resin, and the demand for better compounding performance has increased. The compounding performance of an ATH-containing resin is generally determined by viewing the power draw on the motor of the compounding machine used in compounding the ATH-containing resin. Less variations of the power draw on the motor of the compounding machine translates to less wear on the compounder engine, better compounded resins, and higher throughputs of the ATH-containing resin during compounding.

Thus, because there is a demand for higher throughputs in the compounding of ATH-flame retarded resins and the performance of the ATH-flame retarded synthetic resin is a critical attribute that is linked to the ATH, compounders would benefit from, and thus there is a demand for, an ATH which, during compounding, would allow for higher throughputs in compounding machines like Buss Ko-kneaders, twin-screw extruders or other suitable machines.

### BRIEF DESCRIPTION OF THE FIGURES

Figure 1 shows the specific pore volume V as a function of the applied pressure for the second intrusion test run and an ATH grade no. 1, an ATH according to the present invention, in comparison with standard grades.
Figure 2 shows the specific pore volume V plotted against the pore radius r for the second intrusion test run and an ATH grade no. 1, an ATH according to the present invention, in comparison with standard grades.
Figure 3 shows the normalized specific pore volume for an ATH grade no. 1, an ATH according to the present invention, in comparison with standard grades, the graph was generated with the maximum specific pore volume for each ATH grade set at 100%, and the other specific volumes of the corresponding ATH grade were divided by this maximum value.
Figure 4 shows the specific pore volume V as a function of the applied pressure for the second intrusion test run and an ATH grade no. 2, an ATH according to the present invention, in comparison with standard grades.
Figure 5 shows the specific pore volume V plotted against the pore radius r for the second intrusion test run and an ATH grade no. 2, an ATH according to the present invention, in comparison with standard grades.
Figure 6 shows the normalized specific pore volume for an ATH grade no.2, an ATH according to the present invention, in comparison with standard grades, the graph was generated with the maximum specific pore volume for each ATH grade set at 100%, and the other specific volumes of the corresponding ATH grade were divided by this maximum value.
Figure 7 shows the specific pore volume V as a function of the applied pressure for the second intrusion test run and an ATH grade no. 3, which is not an ATH according to the present invention, in comparison with a standard grade.
Figure 8 shows the specific pore volume V plotted against the pore radius r for the second intrusion test run and an ATH grade no. 3, which is not an ATH according to the present invention, in comparison with a standard grade.
Figure 9 shows the normalized specific pore volume for an ATH grade no. 3, which is not an ATH according to the present invention, in comparison with standard grades, the graph was generated with the maximum specific pore volume for each ATH grade set at 100%, and the other specific volumes of the corresponding ATH grade were divided by this maximum value.
Figure 10 shows the power draw on the motor of a discharge extruder for the inventive aluminum hydroxide grade no. 1 used in the Example 1.
Figure 11 shows the power draw on the motor of a discharge extruder for the comparative aluminum hydroxide grade OL-104 LE used in Example 2.

### SUMMARY OF THE INVENTION

Higher compounding throughputs can be achieved through the use of ATH's with better wettability in the selected synthetic material. An ATH with a poor wettability in the synthetic resin leads to higher variations in the power draw of the compounder motor during compounding, which in turn leads to, at best, a moderate compound quality, low throughputs, and, over time, can represent a considerable risk for damage to the engine of the compounding machine.

The present invention relates to ATH particles having a median pore radius ("r₅₀") in the range of from 0.09 to 0.33 µm, a BET, as determined by DIN-66132, in the range of from 1 to 15 m²/g, and a maximum specific pore volume ("Vₘₐₓ") in the range of from 300 to 480 mm3/g.

In another embodiment, the present invention relates to a flame retarded polymer formulation comprising at least one synthetic resin and in the range of from 5 wt% to 90 wt% of said ATH particles.

### DETAILED DESCRIPTION OF THE INVENTION

The wettability of ATH particles with resins depends on the morphology of the ATH particles, and the inventors hereof have unexpectedly discovered that the ATH particles according to the present invention have an improved wettability in relation to ATH particles currently available. While not wishing to be bound by theory, the inventors hereof believe that this improved wettability is attributable to an improvement in the morphology of the ATH particles disclosed herein.

Again, while not wishing to be bound by theory, the inventors hereof believe that this improved morphology is attributable to the specific pore volume and/or the median pore radius ("r₅₀") of the ATH product particles of the present invention. The inventors hereof believe that, for a given polymer molecule, an ATH product having a higher structured aggregate contains more and bigger pores and seems to be more difficult to wet, leading to difficulties (higher variations of the power draw on the motor) during compounding in kneaders like Buss Ko-kneaders or twin-screw extruders or other machines known in the art and used to this purpose. Therefore, the inventors hereof have discovered that an ATH filler characterized by smaller median pore sizes and/or lower total pore volumes correlates with an improved wetting with polymeric materials and thus results in improved compounding behavior, i.e. less variations of the power draw of the engines (motors) of compounding machines used to compound a flame retarded resin containing the ATH filler.

### ATH Particles of the Present Invention

The aluminum hydroxide particles according to the present invention are characterized by a certain median pore radius and/or a lower total specific pore volume at 1000 bar, Vₘₐₓ. as determined by mercury porosimetry. The r₅₀ and the Vₘₐₓ of the ATH particles according to the present invention can be derived from mercury porosimetry. The theory of mercury porosimetry is based on the physical principle that a non-reactive, non-wetting liquid will not penetrate pores until sufficient pressure is applied to force its entrance. Thus, the higher the pressure necessary for the liquid to enter the pores, the smaller the pore size. A smaller pore size and/or a lower total specific pore volume was found to correlate to better wettability of the aluminum hydroxide particles. The pore size of the aluminum hydroxide particles of the present invention can be calculated from data derived from mercury porosimetry using a Porosimeter 2000 from Carlo Erba Strumentazione, Italy. According to the manual of the Porosimeter 2000, the following equation is used to calculate the pore radius r from the measured pressure p: r = -2 γ cos(θ)/p; wherein θ is the wetting angle and γ is the surface tension. The measurements taken herein used a value of 141.3° for θ: and γ was set to 480 dyn/cm.

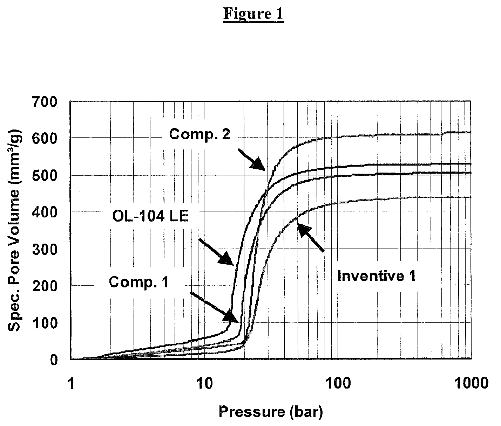

In order to improve the repeatability of the measurements, the pore size of the ATH particles was calculated from the second ATH intrusion test run, as described in the manual of the Porosimeter 2000. The second test run was used because the inventors observed that an amount of mercury having the volume V₀ remains in the sample of the ATH particles after extrusion, i.e. after release of the pressure to ambient pressure. Thus, the r₅₀ can be derived from this data as explained below with reference to Figures 1, 2, and 3.

In the first test run, an ATH sample was prepared as described in the manual of the Porosimeter 2000, and the pore volume was measured as a function of the applied intrusion pressure p using a maximum pressure of 1000 bar. The pressure was released and allowed to reach ambient pressure upon completion of the first test run. A second intrusion test run (according to the manual of the Porosimeter 2000) utilizing the same ATH sample, unadulterated, from the first test run was performed, where the measurement of the specific pore volume V(p) of the second test run takes the volume V₀ as a new starting volume, which is then set to zero for the second test run.

In the second intrusion test run, the measurement of the specific pore volume V(p) of the sample was again performed as a function of the applied intrusion pressure using a maximum pressure of 1000 bar. Figure 1 shows the specific pore volume V as a function of the applied pressure for the second intrusion test run and an ATH, grade no. 1, according to the present invention in comparison with current commercially available ATH products. The pore volume at 1000 bar, i.e. the maximum pressure used in the measurement, is referred to as Vₘₐₓ herein.

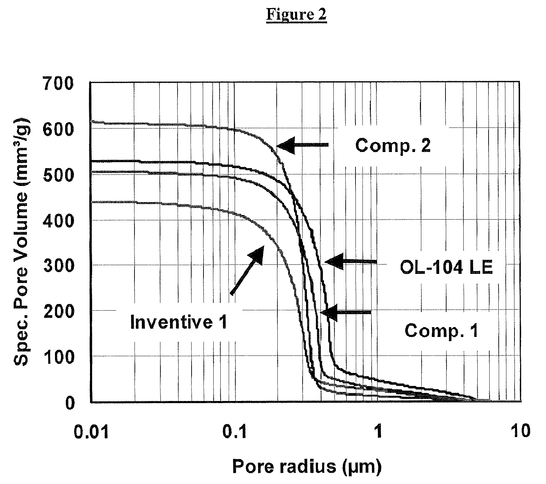

From the second ATH intrusion test run, the pore radius r was calculated by the Porosimeter 2000 according to the formula r = -2 γ cos(θ)/p; wherein θ is the wetting angle, γ is the surface tension and p the intrusion pressure. For all r-measurements taken herein, a value of 141.3° for θ was used and γ was set to 480 dyn/cm. The specific pore volume can thus be plotted against the pore radius r. Figure 2 shows the specific pore volume V of the second intrusion test run (using the same sample) plotted against the pore radius r.

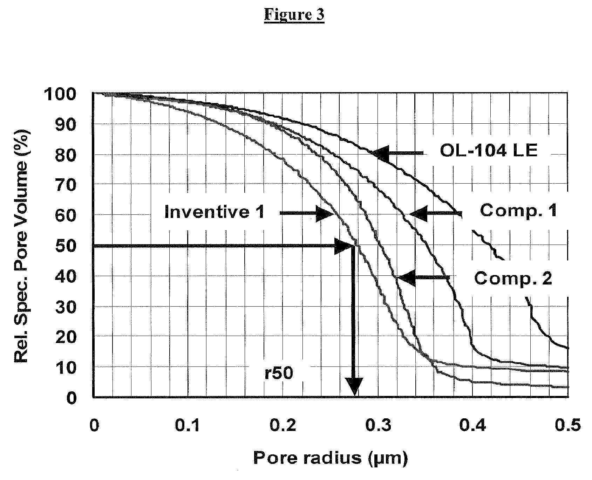

Figure 3 shows the normalized specific pore volume of the second intrusion test run plotted against the pore radius r, i.e. in this curve, the maximum specific pore volume of the second intrusion test run, Vₘₐₓ, was set to 100% and the other specific volumes for that particular ATH were divided by this maximum value. The pore radius at 50% of the relative specific pore volume, by definition, is called median pore radius r₅₀ herein. For example, according to Figure 3, the median pore radius r₅₀ for an ATH according to the present invention, i.e. Inventive 1, is 0.277 µm.

The procedure described above was repeated using a sample of ATH particles according to the present invention, and the ATH particles were found to have an r₅₀, i.e. a pore radius at 50% of the relative specific pore volume, in the range of from 0.09 to 0.33 µm. In preferred embodiments of the present invention, the r₅₀ of the ATH particles is in the range of from 0.20 to 0 33µm, more preferably in the range of from 0.2 to 0.3µm. In other preferred embodiments, the r₅₀ is in the range of from 0.185 to 0.325µm, more preferably in the range of from 0.185 to 0.25 µm. In still other preferred embodiments, the r₅₀ is in the range of from 0.09 to 0.21 µm, more preferably in the range of from 0.09 to 0.165µm.

The ATH particles of the present invention are characterized as having a Vₘₐₓ, i.e. maximum specific pore volume at 1000 bar, in the range of from 300 to 480 mm³/g. In preferred embodiments of the present invention, the Vₘₐₓ of the ATH particles is in the range of from t 390 to 480 mm³/g, more preferably in the range of from 410 to 450 mm³/g. In other preferred embodiments, the Vₘₐₓ is in the range of from 400 to 480 mm³/g, more preferably in the range of from 450 to 480 mm³/g.

The ATH particles of the present invention can also be characterized as having an oil absorption, as determined by ISO 787-5: 1980 of in the range of from 1 to 35%. In some preferred embodiments, the ATH particles of the present invention are characterized as having an oil absorption in the range of from 23 to 30%, more preferably in the range of from 25% to 28%. In other preferred embodiments, the ATH particles of the present invention are characterized as having an oil absorption in the range of from 25% to 32%, more preferably in the range of from 26% to 30%. In yet other preferred embodiments, the ATH particles of the present invention are characterized as having an oil absorption in the range of from 25 to 35% more preferably in the range of from 27% to 32%. In other embodiments, the oil absorption of the ATH particles according to the present invention are in the range of from 19% to 23%, and in still other embodiments, the oil absorption of the ATH particles according to the present invention is in the range of from 21% to 25%.

The ATH particles according to the present invention are characterized as having a BET specific surface area, as determined by DIN-66132, in the range of from 1 to 15 m²/g. In preferred embodiments, the ATH particles according to the present invention have a BET specific surface in the range of from 3 to 6 m²/g, more preferably in the range of from 3.5 to 5.5 m²/g. In other preferred embodiments, the ATH particles according to the present invention have a BET specific surface of in the range of from 6 to 9 m²/g, more preferably in the range of from 6.5 to 8.5 m²/g. In still other preferred embodiments, the ATH particles according to the present invention have a BET specific surface in the range of from 9 to 15 m²/g, more preferably in the range of from 10.5 to 12.5 m²/g.

The ATH particles according to the present invention can also be characterized as having a d₅₀ in the range of from 0.5 to 2.5 µm. In preferred embodiments, the ATH particles according to the present invention have a d₅₀ in the range of from 1.5 to 2.5µm, more preferably in the range of from 1.8 to 2.2 µm. In other preferred embodiments, the ATH particles according to the present invention have a d₅₀ in the range of from 1.3 to 2.0 µm, more preferably in the range of from 1.4 to 1.8 µm. In still other preferred embodiments, the ATH particles according to the present invention have a d₅₀ in the range of from 0.9 to 1.8 µm, more preferably in the range of from 1.1 to 1.5 µm.

It should be noted that all particle diameter measurements, i.e., d₅₀, disclosed herein were measured by laser diffraction using a Cilas 1064 L laser spectrometer from Quantachrome. Generally, the procedure used herein to measure the d₅₀, can be practiced by first introducing a suitable water-dispersant solution (preparation see below) into the sample-preparation vessel of the apparatus. The standard measurement called "Particle Expert" is then selected, the measurement model "Range 1" is also selected, and apparatus-internal parameters, which apply to the expected particle size distribution, are then chosen. It should be noted that during the measurements the sample is typically exposed to ultrasound for about 60 seconds during the dispersion and during the measurement. After a background measurement has taken place, from 75 to 100 mg of the sample to be analyzed is placed in the sample vessel with the water/dispersant solution and the measurement started. The water/dispersant solution can be prepared by first preparing a concentrate from 500 g Calgon, available from KMF Laborchemie, with 3 liters of CAL Polysalt, available from BASF. This solution is made up to 10 liters with deionized water. 100 ml of this original 10 liters is taken and in turn diluted further to 10 liters with deionized water, and this final solution is used as the water-dispersant solution described above.

### Making of ATH Particles of the Present Invention

The ATH particles of the present invention can be made by several processes such as, for example, by spray drying a slurry produced from, for example, a process such as that described below, and dry-milling; mill drying a slurry or filter cake produced from, for example, a process such as that described below, with optional deagglomeration; and wet milling followed by spray drying. For example, see those processes disclosed US patent applications 60/818,632; 60/899,316; 60/891,746; 60/891,745; 60/818,633; and 60/818,670In some embodiments, the ATH particles of the present invention are made by a process comprising wet-milling an ATH slurry containing in the range of from 1 to 40 wt %, based on the total weight of the slurry, ATH particles. "Wet-milling" as used herein is meant to refer to the contacting of the ATH slurry with a milling media in the presence of a liquid. Liquids suitable for use in wet-milling herein are any liquids that do not substantially solubilize the ATH, preferably the liquid is water. In some wet-milling processes suitable for producing ATH particles according to the present invention, the slurry may also contain a suitable dispersing agent.

The milling media used in the wet-milling can be balls, rods, or other shapes made of various materials Some common materials of construction for the milling media include ceramic, steel, aluminum, glass or zirconium oxide (ZrO₂) For ceramic milling media, the density should be above 2.5 g/cm³. Preferably, metal-based milling media with a density of at least 1.5 g/cm³ are used, preferably in the range of from 2.0 to 2.5 g/cm³. In preferred wet-milling processes, the milling media is selected from those media having a general spherical shape, more preferably spherical milling media having a diameter in the range of from 0.1 mm to 1.0 mm, more preferably the milling media is a zirconium milling media, most preferably zirconium oxide.

The ATH slurry that is wet-milled in the practice of the present invention can be obtained from any process used to produce ATH particles. Preferably the slurry is obtained from a process that involves producing ATH particles through precipitation and filtration.

The wet-milling of the ATH slurry results in a milled ATH slurry that is recovered from the wet-milling operation by any technique commonly used to recover milled products from wet-milling operations. The recovered milled ATH slurry is then subjected to drying. Any drying method known in the art that is suitable for drying an ATH slurry can be used. Non-limiting examples of drying methods include spray drying, using spray driers such as those available from the Niro company/Sweden, flash drying or cell mill drying using mill-driers commercially available from the Atritor company or those available from Altenburger Maschinen Jaeckering, GmbH. In some embodiments, the milled ATH slurry is spray dried, and in other embodiments, the milled ATH slurry is dried using a mill-drier.

### Use as a Flame Retardant

The ATH particles according to the present invention can be used as a flame retardant in a variety of synthetic resins. Non-limiting examples of thermoplastic resins where the ATH particles find use include polyethylene, ethylene-propylene copolymer, polymers and copolymers of C₂ to C₈ olefins (α-olefin) such as polybutene, poly(4-methylpentene-1) or the like, copolymers of these olefins and diene, ethylene-acrylate copolymer, polystyrene, ABS resin, AAS resin, AS resin, MBS resin, ethylene-vinyl chloride copolymer resin, ethylene-vinyl acetate copolymer resin, ethylene-vinyl chloride-vinyl acetate graft polymer resin, vinylidene chloride, polyvinyl chloride, chlorinated polyethylene, vinyl chloride-propylene copolymer, vinyl acetate resin, phenoxy resin, and the like. Further examples of suitable synthetic resins include thermosetting resins such as epoxy resin, phenol resin, melamine resin, unsaturated polyester resin, alkyd resin and urea resin and natural or synthetic rubbers such as EPDM, butyl rubber, isoprene rubber, SBR, NIR, methane rubber, polybutadiene rubber, acrylic rubber, silicone rubber, fluoro-elastomer, NBR and chloro-sulfonated polyethylene are also included. Further included are polymeric suspensions (latices).

Preferably, the synthetic resin is a polyethylene-based resins such as high-density polyethylene, low-density polyethylene, linear low-density polyethylene, ultra low-density polyethylene, EVA (ethylene-vinyl acetate resin), EEA (ethylene-ethyl acrylate resin), EMA (ethylene-methyl acrylate copolymer resin), EAA (ethylene-acrylic acid copolymer resin) and ultra high molecular weight polyethylene; and polymers and copolymers of C₂ to C₈ olefins (α-olefin) such as polybutene and poly(4-methylpentene-1), polyvinyl chloride and rubbers. In a more preferred embodiment, the synthetic resin is a polyethylene-based resin.

The inventors have discovered that by using the ATH particles according to the present invention as flame retardants in synthetic resins, better compounding performance, of the aluminum hydroxide containing synthetic resin can be achieved. The better compounding performance is highly desired by those compounders, manufactures, etc. producing highly filled flame retarded compounds and final extruded or molded articles out of ATH-containing synthetic resins. By highly filled, it is meant those containing the flame retarding amount of ATH, discussed below.

By better compounding performance, it is meant that variations in the amplitude of the energy level of compounding machines like Buss Ko-kneaders or twin screw extruders needed to mix a synthetic resin containing ATH particles according to the present invention are smaller than those of compounding machines mixing a synthetic resin containing conventional ATH particles. The smaller variations in the energy level allows for higher throughputs of the ATH-containing synthetic resins to be mixed or extruded and/or a more uniform (homogenous) material.

Thus, in one embodiment, the present invention relates to a flame retarded polymer formulation comprising at least one synthetic resin, selected from those described above, in some embodiments only one and a flame retarding amount of ATH particles according to the present invention, and extruded and/or molded article made from the flame retarded polymer formulation.

By a flame retarding amount of the ATH, it is generally meant in the range of from 5 wt% to 90 wt%, based on the weight of the flame retarded polymer formulation, and more preferably from 20 wt% to 70 wt%, on the same basis. In a most preferred embodiment, a flame retarding amount is from 30 wt% to 65 wt% of the ATH particles, on the same basis.

The flame retarded polymer formulation can also contain other additives commonly used in the art. Non-limiting examples of other additives that are suitable for use in the flame retarded polymer formulations of the present invention include extrusion aids such as polyethylene waxes, Si-based extrusion aids, fatty acids; coupling agents such as amino-, vinyl- or alkyl silanes or maleic acid grafted polymers; sodium stearate or calcium sterate; organoperoxides; dyes; pigments; fillers; blowing agents; deodorants; thermal stabilizers; antioxidants; antistatic agents; reinforcing agents; metal scavengers or deactivators; impact modifiers; processing aids; mold release aids, lubricants; anti-blocking agents; other flame retardants; UV stabilizers; plasticizers; flow aids; and the like. If desired, nucleating agents such as calcium silicate or indigo can be included in the flame retarded polymer formulations also. The proportions of the other optional additives are conventional and can be varied to suit the needs of any given situation.

The methods of incorporation and addition of the components of the flame-retarded polymer formulation is conducted is not critical to the present invention and can be any known in the art so long as the method selected involves substantially uniform mixing. For example, each of the above components, and optional additives if used, can be mixed using a Buss Ko-kneader, internal mixers, Farrel continuous mixers or twin screw extruders or in some cases also single screw extruders or two roll mills. The flame retarded polymer formulation can then be molded in a subsequent processing step, if so desired. In some embodiments, apparatuses can be used that thoroughly mix the components to form the flame retarded polymer formulation and also mold an article out of the flame retarded polymer formulation. Further, the molded article of the flame-retardant polymer formulation may be used after fabrication for applications such as stretch processing, emboss processing, coating, printing, plating, perforation or cutting. The molded article may also be affixed to a material other than the flame-retardant polymer formulation of the present invention, such as a plasterboard, wood, a block board, a metal material or stone. However, the kneaded mixture can also be inflation-molded, injection-molded, extrusion-molded, blow-molded, press-molded, rotation-molded or calender-molded.

In the case of an extruded article, any extrusion technique known to be effective with the synthetic resins mixture described above can be used. In one exemplary technique, the synthetic resin, aluminum hydroxide particles, and optional components, if chosen, are compounded in a compounding machine to form a flame-retardant resin formulation as described above. The flame-retardant resin formulation is then heated to a molten state in an extruder, and the molten flame-retardant resin formulation is then extruded through a selected die to form an extruded article or to coat for example a metal wire or a glass fiber used for data transmission.

The above description is directed to several embodiments of the present invention. The following examples will illustrate the present invention, but are not meant to be limiting in any manner

### EXAMPLES

The r₅₀ and Vₘₐₓ described in the examples below was derived from mercury porosimetry using a Porosimeter 2000, as described above. All d₅₀, BET, oil absorption, etc., unless otherwise indicated, were measured according to the techniques described above Also, the term "inventive aluminum hydroxide grade" and "inventive filler" as used in the examples is meant to refer to an ATH according to the present invention, and "comparative aluminum hydroxide grade" is meant to refer to an ATH that is commercially available and not according to the present invention.

### EXAMPLE 1

By seeding a pregnant sodium aluminate liquor as e.g. disclosed in EP 1 206 412 B1, a synthetic aluminium hydroxide grade with a median particle size of d₅₀ = 2.43 µm and a specific surface of 2.6 m²/g was produced. Common separation and filtration techniques were used to separate said synthetic aluminum hydroxide; after subsequent washing steps on belt filters, the resulting aluminum hydroxide filter paste with a solid content of 61 wt% was liquefied by adding a sufficient quantity of the dispersing agent Antiprex A40 from Ciba until the viscosity of the slurry was about 150 cPoise. The slurry was fed into a pearl mill, type KD 200 D from Bachofen/Switzerland. This mill contained 270 kg of small beads made of zirconium oxide with a diameter of 0.6 mm The throughput of the mill was controlled so that after drying by means of a Niro F 100 spray drier and conveying of the inventive aluminum hydroxide into a silo the resulting d₅₀ was 1.89 µm and the specific surface was 4.9 m²/g. In the present example, the throughput was about 3 m³/h. Figure 1 shows the specific pore volume of the inventive aluminum hydroxide grade no.1 as a function of the applied pressure of the second intrusion test run. Figure 2 shows the specific pore volume of the inventive aluminum hydroxide grade no. 1 as a function of the pore radius. Figure 3 shows the normalized specific pore volume of the inventive aluminum hydroxide grade no. 1 as a function of the pore radius on a linear scale. The product properties of the inventive aluminum hydroxide grade no. 1 are contained in Table 1, below.

### EXAMPLE 2 - COMPARATIVE

The product properties of the comparative aluminum hydroxide grade Martinal OL-104 LE produced by Martinswerk GmbH and the product properties of two competitive aluminum hydroxide grades "Competitive 1" and "Competitive 2" are also shown in Table 1.

| **Table 1** | | | | |
|---|---|---|---|---|
| | **Median pore radius ("r₅₀") (µm)** | **Maximum specific pore volume Vₘₐₓ (mm³/g)** | **Median particle size d₅₀ (µm)** | **Specific BET surface (m²/g)** |
| **Comparative ATH OL**-**104 LE** | 0.419 | 529 | 1.83 | 3.2 |
| **Comparative 1** | 0.353 | 504 | 1.52 | 3.2 |
| **Comparative 2** | 0.303 | 615 | 1 61 | 4.0 |
| **Inventive ATH grade no**. **1** | 0.277 | 439 | 1.89 | 4.9 |

As can be seen in Table 1, the inventive aluminum hydroxide grade no. 1, an ATH according to the present invention, has the lowest median pore radius and the lowest maximum specific pore volume.

### EXAMPLE 3

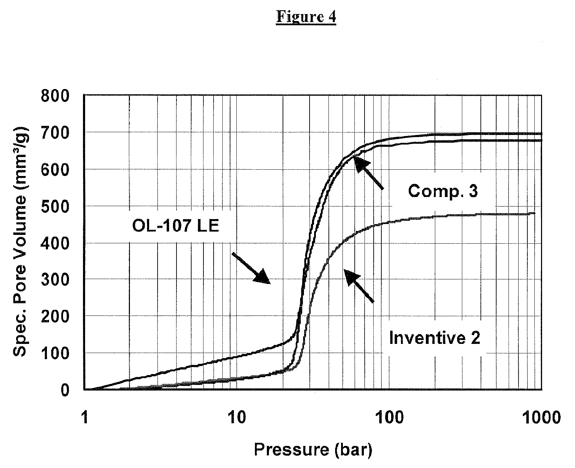

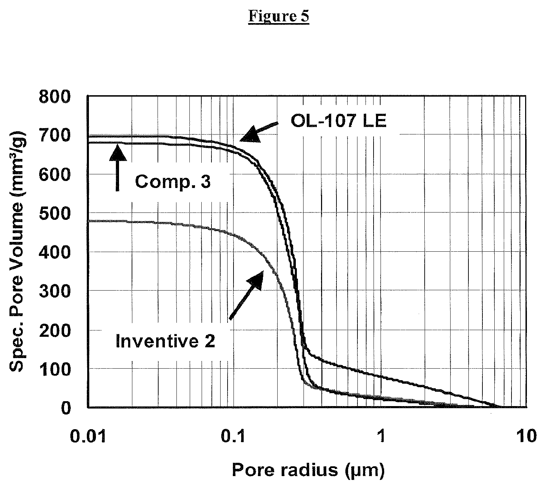

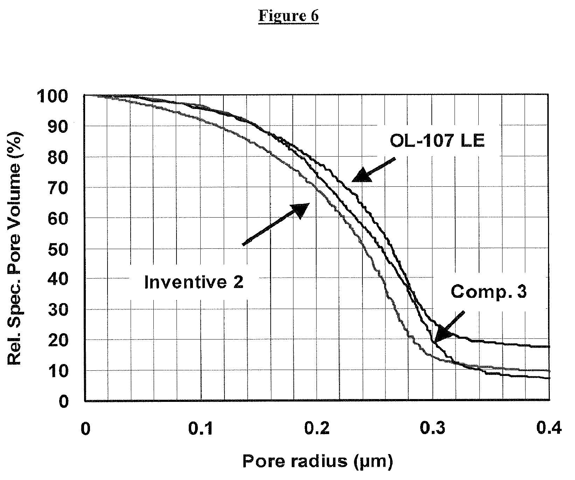

By seeding a pregnant sodium aluminate liquor as e.g., disclosed in EP 1 206 412 B1, a synthetic aluminium hydroxide grade with a median particle size of d₅₀ = 2.43µm and a specific surface of 2.6 m²/g was produced. Common separation and filtration techniques were used to separate said synthetic aluminum hydroxide; after subsequent washing steps on belt filters, the resulting aluminum hydroxide filter paste with a solid content of 61 wt% was liquefied by adding a sufficient quantity of the dispersing agent Antiprex A40 from Ciba until the viscosity of the slurry was about 150 cPoise. The slurry was fed into a pearl mill, type KD 200 D from Bachofen/Switzerland. This mill contained 270 kg of small beads made of zirconium oxide with a diameter of 0.6 mm, The throughput of the mill was controlled so that after drying by means of a Niro F 100 spray drier and conveying of the inventive aluminum hydroxide into a silo the resulting d₅₀ was 1.44 µm and the specific surface was 6.7 m²/g. In the present example, the throughput was about 2 m³/h. Figure 4 shows the specific pore volume of the inventive aluminum hydroxide grade no. 2 as a function of the applied pressure of the second intrusion test run. Figure 5 shows the specific pore volume of the inventive aluminum hydroxide grade no. 2 as a function of the pore radius, Figure 6 shows the normalized specific pore volume of the inventive aluminum hydroxide grade no. 2 as a function of the pore radius on a linear scale. The product properties of the inventive aluminum hydroxide grade no. 2 are contained in Table 2, below.

### EXAMPLE 4 - COMPARATIVE

The product properties of the comparative aluminum hydroxide grade Martina! OL-107 LE produced by Martinswerk GmbH and the product properties of the competitive aluminum hydroxide grade "Competitive 3" are also shown in Table 2.

| **Table 2** | | | | |
|---|---|---|---|---|
| | **Median pore radius ("r₅₀") (µm)** | **Maximum specific pore volume V_{MAX} (mm³/g)** | **Median particle size d₅₀ (µm)** | **Specific BET surface (m²/g)** |
| **Comparative ATH OL**-**107 LE** | 0.266 | 696 | 1.35 | 6.2 |
| **Comparative 3** | 0.257 | 679 | 1.23 | 6.3 |
| **Inventive ATH grade no. 2** | 0.242 | 479 | 1.44 | 6.7 |

As can be seen in Table 2, the inventive aluminum hydroxide grade no. 2 has the lowest median pore radius and the lowest maximum specific pore volume.

### EXAMPLE 5 (not according to the invention)

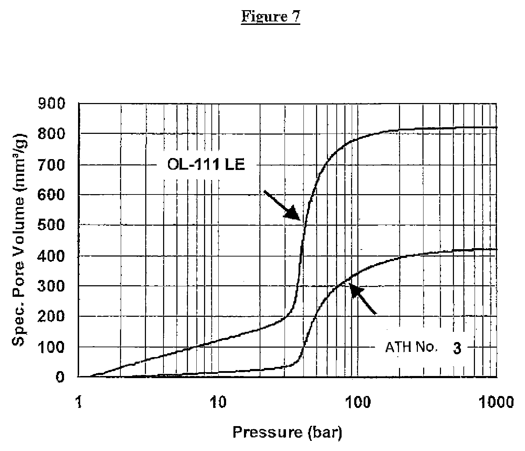

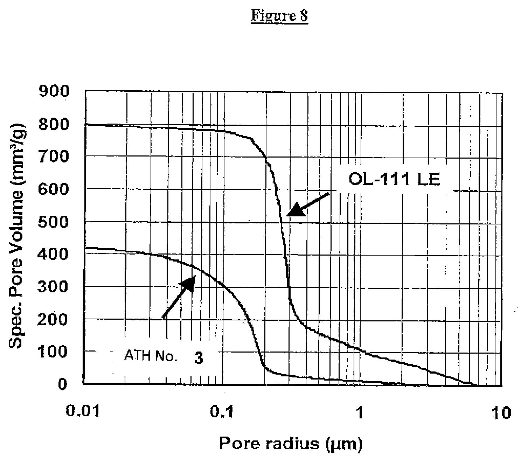

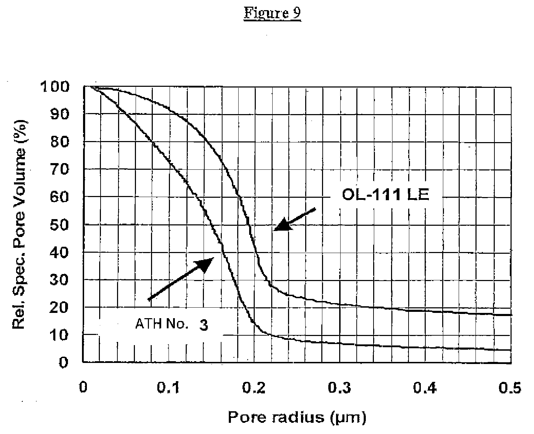

By seeding a pregnant sodium aluminate liquor as e.g. disclosed in EP 1 206 412 B1, a synthetic aluminium hydroxide grade with a median particle size of d₅₀ = 2.43 µm and a specific surface of 2.6 m²/g was produced. Common separation and filtration techniques were used to separate said synthetic aluminum hydroxide; after subsequent washing steps on belt filters, the resulting aluminum hydroxide filter paste with a solid content of 61 wt.% was liquefied by adding a sufficient quantity of the dispersing agent Antiprex A40 from Ciba until the viscosity of the slurry was about 150 cPoise. The slurry was fed into a pearl mill, type KD 200 D from Bachofen/Switzerland. This mill contained 270 kg of small beads made of zirconium dioxide with a diameter of 0.6 mm. The throughput of the mill was controlled so that after drying by means of a Niro F 100 spray drier and conveying of the aluminum hydroxide into a silo the resulting d₅₀ was 1.36 µm and the specific surface was 10.0 m²/g. In the present example, the throughput was about 0.75 m³/h. Figure 7 shows the specific pore volume of the aluminum hydroxide grade no. 3 as a function of the applied pressure of the second intrusion test run. Figure 8 shows the specific pore volume of the aluminum hydroxide grade no. 3 as a function of the pore radius. Figure 9 shows the normalized specific pore volume of the aluminum hydroxide grade no. 3 as a function of the pore radius on a linear scale. The product properties of the aluminum hydroxide grade no. 3 are contained in Table 3, below.

### EXAMPLE 6 - COMPARATIVE

The product properties of the comparative aluminum hydroxide grade Martinal OL-111 LE produced by Martinswerk GmbH are also shown in Table 3.

| **Table 3** | | | | |
|---|---|---|---|---|
| | **Median pore radius ("r₅₀") (µm)** | **Maximum specific pore volume Vₘₐₓ (mm³/g)** | **Median particle size d₅₀ (µm)** | **Specific BET surface (m²/g)** |
| **Comparative ATH OL**-**111LE** | 0.193 | 823 | 1.23 | 10.1 |
| **ATH grade no. 3** | 0.175 | 588 | 1.36 | 10.0 |

As can be seen in Table 3, the aluminum hydroxide grade no. 3 has a lower median pore radius and a lower maximum specific pore volume.

### EXAMPLE 7

396.9 g (100 phr) of ethylene vinyl acetate (EVA) Escorene™ Ultra UL00119 from ExxonMobil was mixed during about 20min on a two roll mill W150M from the Collin company with 595.4 g (150 phr) of the inventive aluminum hydroxide grade no. 1 in a usual manner familiar to a person skilled in the art, together with 4.8 g (1.2 phr) of aminosilane AMEO from Degussa AG and 2.9 g (0.75 phr) of the antioxidant Ethanox® 310 from Albemarle Corporation. The aminosilane ensures better coupling of the filler to the polymer matrix. The temperature of the two rolls was set to 130 °C. The ready compound was removed from the mill, and after cooling to room temperature, was further reduced in size to obtain granulates suitable for compression molding in a two platen press or for feeding a laboratory extruder to obtain extruded strips for further evaluation. In order to determine the mechanical properties of the flame retardant resin formulation, the granules were extruded into 2mm thick tapes using a Haake Polylab System with a Haake Rheomex extruder. Test bars according to DIN 53504 were punched out of the tape. The results of this experiment are contained in Table 4, below.

### EXAMPLE 8 - COMPARATIVE

396.9 g (100 phr) of ethylene vinyl acetate (EVA) Escorene™ Ultra UL00119 from ExxonMobil was mixed during about 20min on a two roll mill W150M from the Collin company with 595.4 g (150 phr) of the commercially available ATH grade OL-104 LE produced by Martinswerk GmbH in a usual manner familiar to a person skilled in the art, together with 4.8 g (1.2 phr) of aminosilane AMEO from Degussa AG and 2.9 g (= 0.75 phr) of the antioxidant Ethanox® 310 from Albemarle Corporation. The aminosilane ensures better coupling of the filler to the polymer matrix. The temperature of the two rolls was set to 130°C. The ready compound was removed from the mill, and after cooling to room temperature, was further reduced in size to obtain granulates suitable for compression molding in a two platen press or for feeding a laboratory extruder to obtain extruded strips for further evaluation. In order to determine the mechanical properties of the flame retardant resin formulation, the granules were extruded into 2mm thick tapes using a Haake Polylab System with a Haake Rheomex extruder. Test bars according to DIN 53504 were punched out of the tape. The results of this experiment are contained in Table 4, below.

| **Table 4** | | |
|---|---|---|
| | **Comparative with OL-104 LE** | **Inventive filler no. 1** |
| **Melt Flow Index** @ **150°C/21.6 kg (g/10min)** | 1.8 | 1.5 |
| **Tensile strength (MPa)** | 12.9 | 13.4 |
| **Elongation at break (%)** | 221 | 214 |
| **LOI (% O₂)** | 36.2 | 38 |
| **Resistivity before water aging (Ohm·cm)** | 31 x 10¹² | 1.7 x 10¹² |
| **Resistivity after 7d@70°C water aging (Ohm·cm)** | 8.1 x10¹¹ | 8.4 x 10¹¹ |
| **Water pickup (%)** | 1.25 | 1.67 |

As can be seen in Table 4, within the experimental error, the inventive aluminum hydroxide grade no. 1 has similar mechanical, theological, electrical and flame retardant properties as the comparative grade Martinal OL-104 LE.

### EXAMPLE 9

396.9 g (100 phr) of ethylene vinyl acetate (EVA) Escorene™ Ultra UL00119 from ExxonMobil was mixed during about 20min on a two roll mill W150M from the Collin company with 595.4 g (150 phr) of the inventive filler no. 2 in a usual manner familiar to a person skilled in the art, together with 4.8 g (1.2 phr) of aminosilane AMEO from Degussa AG and 2.9 g (0.75 phr) of the antioxidant Ethanox® 310 from Albemarle Corporation. The aminosilane ensures better coupling of the filler to the polymer matrix. The temperature of the two rolls was set to 130°C. The ready compound was removed from the mill, and after cooling to room temperature, was further reduced in size to obtain granulates suitable for compression molding in a two platen press or for feeding a laboratory extruder to obtain extruded strips for further evaluation. In order to determine the mechanical properties of the flame retardant resin formulation, the granules were extruded into 2mm thick tapes using a Haake Polylab System with a Haake Rheomex extruder. Test bars according to DIN 53504 were punched out of the tape. The results of this experiment are contained in Table 5, below.

### EXAMPLE 10 - COMPARATIVE

396.9 g (100 phr) of ethylene vinyl acetate (EVA) Escorene Ultra UL00119 from ExxonMobil was mixed during about 20min on a two roll mill W150M from the Collin company with 595.4 g (150 phr) of the commercially available ATH grade OL-107 LE produced by Martinswerk GmbH in a usual manner familiar to a person skilled in the art, together with 4.8 g (1.2 phr) of aminosilane AMEO from Degussa AG and 2.9 g (= 0 75 phr) of the antioxidant Ethanox® 310 from Albemarle Corporation. The aminosilane ensures better coupling of the filler to the polymer matrix. The temperature of the two rolls was set to 130°C. The ready compound was removed from the mill, and after cooling to room temperature, was further reduced in size to obtain granulates suitable for compression molding in a two platen press or for feeding a laboratory extruder to obtain extruded strips for further evaluation. In order to determine the mechanical properties of the flame retardant resin formulation, the granules were extruded into 2mm thick tapes using a Haake Polylab System with a Haake Rheomex extruder. Test bars according to DIN 53504 were punched out of the tape. The results of this experiment are contained in Table 5, below.

| **Table 5** | | |
|---|---|---|
| | **Comparative with OL-107 LE** | **Inventive filler no. 2** |
| **Melt Flow Index @ 150°C/21.6 kg (g/10min)** | 1.1 | 1.25 |
| **Tensile strength (MPa)** | 13.9 | 13.6 |
| **Elongation at break (%)** | 204 | 203 |
| **LOI (% O₂)** | 38.7 | 38.2 |
| **Resistivity before water aging (Ohm·cm)** | 2.6 x 10¹² | 1.5 x 10¹² |
| **Resistivity after 7d@70°C water aging (Ohm·cm)** | 6.3 x 10¹¹ | 7.9 x 10¹¹ |
| **Water pickup (%)** | 2.78 | 1.67 |

As can be seen in Table 5, within the experimental error, the inventive aluminum hydroxide grade no. 2 has similar mechanical, rheological, electrical and flame retardant properties as the comparative grade Martinal® OL-107 LE.

### EXAMPLE 11 (not according to the invention)

396.9 g (100 phr) of ethylene vinyl acetate (EVA) Escorene™ Ultra UL00119 from ExxonMobil was mixed during about 20min on a two roll mill W150M from the Collin company with 595.4 g (150 phr) of the fillet no. 3 in a usual manner familiar to a person skilled in the art, together1 with 4.8 g (1.2 phr) of aminosilane AMEO from Degussa AG and 2.9 g (0.75 phr) of the antioxidant Ethanox® 310 from Albemarle Corporation. The aminosilane ensures better coupling of the filler to the polymer matrix. The temperature of the two rolls was set to 130°C. The ready compound was removed from the mill, and after cooling to room temperature, was further reduced in size to obtain granulates suitable for compression molding in a two platen press or for feeding a laboratory extruder to obtain extruded strips for further evaluation. In order to determine the mechanical properties of the flame retardant resin formulation, the granules were extruded into 2mm thick tapes using a Haake Polylab System with a Haake Rheomex extruder. Test bars according to DIN 53504 were punched out of the tape. The results of this experiment are contained in Table 6, below.

### EXAMPLE 12 - COMPARATIVE

396.9 g (100 phr) of ethylene vinyl acetate (EVA) Escorene™ Ultra UL00119 from ExxonMobil was mixed during about 20min on a two roll mill W150M from the Collin company with 595.4 g (150 phr) of the commercially available ATH grade OL-111 LE produced by Martinswerk GmbH in a usual manner familiar to a person skilled in the art, together with 4.8 g (1.2 phr) of aminosilane AMEO from Degussa AG and 2.9 g (0.75 phr) of the antioxidant Ethanox® 310 from Albemarle Corporation. The aminosilane ensures better coupling of the filler to the polymer matrix. The temperature of the two rolls was set to 130°C. The ready compound was removed from the mill, and after cooling to room temperature, was further reduced in size to obtain granulates suitable for compression molding in a two platen press or for feeding a laboratory extruder to obtain extruded strips for further evaluation. In order to determine the mechanical properties of the flame retardant resin formulation, the granules were extruded into 2mm thick tapes using a Haake Polylab System with a Haake Rheomex extruder. Test bars according to DIN 53504 were punched out of the tape. The results of this experiment are contained in Table 6, below.

| **Table 6** | | |
|---|---|---|
| | **Comparative with OL-111 LE** | **Filler no. 3** |
| **Melt Flow Index @ 150°C/21**.**6 kg (g/10 min)** | 113 | 1.22 |
| **Tensile strength (MPa)** | 15.7 | 15.2 |
| **Elongation at break (%)** | 183 | 185 |
| **LOI (% O₂)** | 38.6 | 39.6 |

As can be seen in Table 6, within the experimental error, the aluminum hydroxide grade no. 3 has similar mechanical and theological properties as the comparative grade Martinal® OL-111 LE.

It should be noted that the Melt Flow Index was measured according to DIN 53735. The tensile strength and elongation at break were measured according to DIN 53504, and the resistivity before and after water ageing was measured according to DIN 53482 on 100x100x2 mm³ pressed plates. The water pick-up in % is the difference in weight after water aging of a 100x100x2 mm³ pressed plate in a de-salted water bath after 7 days at 70 °C relative to the initial weight of the plate. The oxygen index was measured according to ISO 4589 on 6 x 3 x 150 mm³ samples.

### EXAMPLE 13

The comparative aluminum hydroxide particles Martinal® OL-104 LE of Example 2 and the inventive aluminum hydroxide grade no. 1 of Example 1 were separately used to form a flame-retardant resin formulation. The synthetic resin used was a mixture of EVA Escorene© Ultra UL00328 from ExxonMobil together with a LLDPE grade Escorene® LL1001XV from ExxonMobil, Ethanox® 310 antioxidant available commercially from the Albemarle® Corporation, and an amino silane Dynasylan AMEO from Degussa. The components were mixed on a 46 mm Buss Ko-kneader (L/D ratio = 11) at a throughput of 25 kg/h with temperature settings and screw speed chosen in a usual manner familiar to a person skilled in the art. The amount of each component used in formulating the flame-retardant resin formulation is detailed in Table 7, below.

| **Table 7** | |
|---|---|
| | **Phr (parts per hundred total resin)** |
| **Escorene Ultra UL00328** | 80 |
| **Escorene LL1001XV** | 20 |
| **Aluminum hydroxide** | 150 |
| **AMEO silane** | 1.6 |
| **Ethanox 310** | 0.6 |

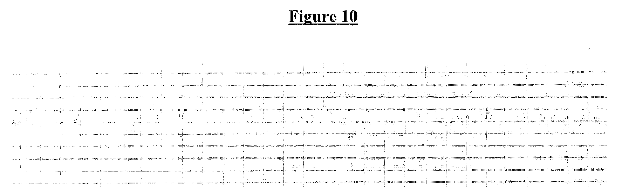

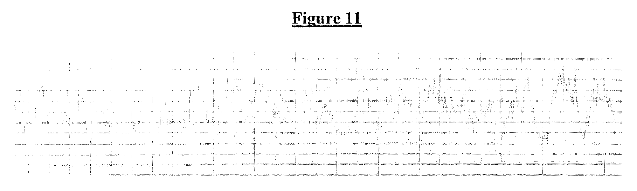

In forming the flame-retardant resin formulation, the AMEO silane and Ethanox® 310 were first blended with the total amount of synthetic resin in a drum prior to Buss compounding. By means of loss in weight feeders, the resin/silane/antioxidant blend was fed into the first inlet of the Buss kneader, together with 50 % of the total amount of aluminum hydroxide, and the remaining 50% of the aluminum hydroxide was fed into the second feeding port of the Buss kneader. The discharge extruder was flanged perpendicular to the Buss Ko-kneader and had a screw size of 70 mm. Figure 10 shows the power draw on the motor of the discharge extruder for the inventive aluminum hydroxide grade no. 1. Figure 11 shows the power draw on the motor of the discharge extruder for the comparative aluminum hydroxide grade OL-104 LE, produced by Martinswerk GmbH.

As demonstrated in Figures 10 and 11, variations in the energy (power) draw of the discharge extruder are significantly reduced when the aluminum hydroxide particles according to the present invention are used in the flame-retardant resin formulation. As stated above, smaller variations in energy level allows for higher throughputs and/or a more uniform (homogenous) flame-retardant resin formulation.

## Claims

1. Aluminium hydroxide ("ATH") particles having a median pore radius ("r₅₀") in the range of from 0.09 to 0.33 µm, a BET, as determined by DIN-66132, in. the range of from 1 to 15 m²/g, and a maximum specific pore volume ("Vₘₐₓ") in the range of from 300 to 480 mm³/g.

2. The ATH particles according to claim 1 wherein the Vₘₐₓ of said ATH particles is in the range of from 390 to 480 mm³/g.

3. The ATH particles according to claim 2 wherein the r₅₀ of said ATH particles is in the range of from 0.20 to 0.33 µm.

4. The ATH particles according to claim 1 wherein the Vₘₐₓ of said ATH particles is in the range of from 400 to 480 mm³/g.

5. The ATH particles according to claim 4 wherein the r₅₀ of said ATH particles is in the range of from 0.185 to 0.325 µm.

6. The ATH particles according to claim 1 wherein the Vₘₐₓ of said ATH particles is in the range of from 450 to 480 mm³/g, and the r₅₀ is in the range of from 0.185 to 0.25 µm.

7. The ATH particles according to claim 1 wherein the r₅₀ of said ATH particles is in the range of from 0.09 to 0.21 µm.

8. The ATH particles according to claim 1 wherein the Vₘₐₓ of said ATH particles is in the range of from 350 to 480 mm³/g.

9. The ATH particles according to claim 8 wherein the r₅₀ of said ATH particles is in the range of from 0.09 to 0.165 µm.

10. The ATH particles according to claim 11 wherein the oil absorption, as determined by ISO 787-5:1980, is in the range of from 1 to 35%.

11. The ATH particles according to claim 1 wherein the d₅₀ is in the range of from 0.5 to 2.5 µm.

12. A flame retarded polymer formulation comprising at least one synthetic resin and in the range of from 5 wt% to 90 wt% ATH particles according to claim 1.

13. The flame retarded polymer formulation according to claim 12 wherein said synthetic resin is selected from thermoplastic resins, thermosetting resins, polymeric suspensions (latices), and polyethylene-based resins.

14. The flame retarded polymer formulation according to claim 13 wherein said synthetic resin is a polyethylene-based resin.

15. The flame retarded polymer formulation according to claim 13 wherein said ATH particles have a d₅₀ in the range of from 0.5 to 2.5 µm.

16. The flame retarded polymer formulation according to claim 13 wherein r₅₀ is in the range of from 0.2 to 0.3 µm, Vₘₐₓ is in the range of from 410 to 450 mm³/g, BET specific surface area is in the range of from 3.5 to 5.5 m²/g, oil absorption is in the range of from 23% to 30%, and d₅₀ is in the range of from 1.3 to 2.5 µm.

17. The flame retarded polymer formulation according to claim 15 wherein the oil absorption of said ATH particles is in the range of from 1 to 35%.

18. The flame retarded polymer formulation according to any of claims 12 or 16-17 wherein said flame retarded polymer formulation contains at least one additional additive selected from extrusion aids; coupling agents; dyes; pigments; fillers; blowing agents; deodorants; thermal stabilizers; antioxidants; antistatic agents; reinforcing agents; metal scavengers or deactivators; impact modifiers; processing aids; mold release aids, lubricants; antiblocking agents; other flame retardants; UV stabilizers; plasticizers; and flow aids.

19. A molded or extruded article formed from the flame retarded polymer formulation of claim 18.

## Patentansprüche

1. Aluminiumhydroxid("ATH")-Teilchen mit einem medianen Porenradius ("r₅₀") im Bereich von 0,09 bis 0,33 µm, einer BET, wie bestimmt gemäß DIN-66132, im Bereich von 1 bis 15 m²/g, und einem maximalen spezifischen Porenvolumen ("Vₘₐₓ") im Bereich von 300 bis 480 mm³/g.

2. ATH-Teilchen nach Anspruch 1, bei denen das Vₘₐₓ der ATH-Teilchen im Bereich von 390 bis 480 mm³/g liegt.

3. ATH-Teilchen nach Anspruch 2, bei denen der r₅₀ der ATH-Teilchen im Bereich von 0,20 bis 0,33 µm liegt.

4. ATH-Teilchen nach Anspruch 1, bei denen das Vₘₐₓ der ATH-Teilchen im Bereich von 400 bis 480 mm³/g liegt.

5. ATH-Teilchen nach Anspruch 4, bei denen der r₅₀ der ATH-Teilchen im Bereich von 0,185 bis 0,325 µm liegt.

6. ATH-Teilchen nach Anspruch 1, bei denen das Vₘₐₓ der ATH-Teilchen im Bereich von 450 bis 480 mm³/g liegt und der r₅₀ im Bereich von 0,185 bis 0,25 µm liegt.

7. ATH-Teilchen nach Anspruch 1, bei denen der r₅₀ der ATH-Teilchen im Bereich von 0,09 bis 0,21 µm liegt.

8. ATH-Teilchen nach Anspruch 1, bei denen das Vₘₐₓ der ATH-Teilchen im Bereich von 350 bis 480 mm³/g liegt.

9. ATH-Teilchen nach Anspruch 8, bei denen der r₅₀ der ATH-Teilchen im Bereich von 0,09 bis 0,165 µm liegt.

10. ATH-Teilchen nach Anspruch 11, bei denen die Ölabsorption, wie bestimmt gemäß ISO 787-5:1980, im Bereich von 1 bis 35% liegt.

11. ATH-Teilchen nach Anspruch 1, bei denen der d₅₀ im Bereich von 0,5 bis 2,5 µm liegt.

12. Flammgehemmte Polymerformulierung, die mindestens ein synthetisches Harz und im Bereich von 5 Gew.-% bis 90 Gew.-% ATH-Teilchen gemäß Anspruch 1 umfasst.

13. Flammgehemmte Polymerformulierung nach Anspruch 12, bei der das synthetische Harz aus thermoplastischen Harzen, duroplastischen Harzen, polymeren Suspensionen (Latizes) und auf Polyethylen basierenden Harzen ausgewählt ist.

14. Flammgehemmte Polymerformullerung nach Anspruch 13, bei der das synthetische Harz ein auf Polyethylen basierendes harz ist.

15. Flammgehemmte Polymerformulierung nach Anspruch 13, bei der die ATH-Teilchen einen d₅₀ im Bereich von 0,5 bis 2,5 µm aufweisen.

16. Flammgehemmte Polymerformulierung nach Anspruch 13, bei der r₅₀ der im Bereich von 0,20 bis 0,3 µm liegt, das Vₘₐₓ im Bereich von 410 bis 450 mm³/g liegt, die spezifische BET Oberfläche im Bereich von 3,5 bis 5,5 m²/g liegt, die Ölabsorption im Bereich von 23 bis 30% liegt und d₅₀ im Bereich von 1,3 bis 2,5 µm liegt.

17. Flammgehemmte Polymerformulierung nach Anspruch 15, bei der die Ölabsorption der ATH-Teilchen im Bereich von 1 bis 35% liegt.

18. Flammgehemmte Polymerformulierung nach einem der Ansprüche 12 oder 16 bis 17, bei der die flammgehemmte Polymerformulierung mindestens ein weiteres Additiv enthält, das aus Extrusionshilfsmitteln, Kupplungsmitteln, Farbstoffen, Pigmenten, Füllstoffen, Blähmitteln, Deodorantien, Thermostabilisatoren, Antioxidantien, Antistatikmitteln, Verstärkungsmitteln, Metallfängern oder Deaktivatoren, Stoßmodifizierungsmitteln, Verarbeitungshilfsmitteln, Formtrennmitteln, Schmiermitteln, Antiblockiermittein, anderen Flammschutzmitteln, UV-Stabilisatoren, Weichmachern und Fließhilfsmitteln ausgewählt ist.

19. Geformter oder extrudierter Gegenstand, der aus der flammgehemmten Polymerformulierung gemäß Anspruch 18 gebildet worden ist.

## Revendications

1. Particules d'hydroxyde d'aluminium (« ATH ») ayant un rayon de pore médian (« r₅₀ ») se situant dans la plage de 0,09 à 0,33 µm, une surface spécifique BET, telle que déterminée par DIN-66132, se situant dans la plage de 1 à 15 m²/g, et un volume poreux spécifique maximal (« Vₘₐₓ ») se situant dans la plage de 300 à 480 mm³/g.

2. Particules d'ATH selon la revendication 1, dans lesquelles le Vₘₐₓ desdites particules d'ATH se situe dans la plage de 390 à 480 mm³/g.

3. Particules d'ATH selon la revendication 2, dans lesquelles le r₅₀ desdites particules d'ATH se situe dans la plage de 0,20 à 0,33 µm.

4. Particules d'ATH selon la revendication 1, dans lesquelles le Vₘₐₓ desdites particules d'ATH se situe dans la plage de 400 à 480 mm³/g.

5. Particules d'ATH selon la revendication 4, dans lesquelles le r₅₀ desdites particules d'ATH se situe dans la plage de 0,185 à 0,325 µm.

6. Particules d'ATH selon la revendication 1, dans lesquelles le Vₘₐₓ desdites particules d'ATH se situe dans la plage de 450 à 480 mm³/g, et le r₅₀ se situe dans la plage de 0,185 à 0,25 µm.

7. Particules d'ATH selon la revendication 1, dans lesquelles le r₅₀ desdites particules d'ATH se situe dans la plage de 0,09 à 0,21 µm.

8. Particules d'ATH selon la revendication 1, dans lesquelles le Vₘₐₓ desdites particules d'ATH se situe dans la plage de 350 à 480 mm³/g.

9. Particules d'ATH selon la revendication 8, dans lesquelles le r₅₀ desdites particules d'ATH se situe dans la plage de 0,09 à 0,165 µm.

10. Particules d'ATH selon la revendication 11, dans lesquelles l'absorption d'huile, telle que déterminée par ISO 787-5 : 1980, se situe dans la plage de 1 à 35 %.

11. Particules d'ATH selon la revendication 1, dans lesquelles le d₅₀ se situe dans la plage de 0,5 à 2,5 µm.

12. Formulation de polymère à retard de flamme comprenant au moins une résine synthétique et dans la plage de 5 % en poids à 90 % en poids des particules d'ATH selon la revendication 1.

13. Formulation de polymère à retard de flamme selon la revendication 12, dans laquelle ladite résine synthétique est choisie parmi les résines thermoplastiques, les résines thermodurcissables, les suspensions polymères (latex) et les résines à base de polyéthylène.

14. Formulation de polymère à retard de flamme selon la revendication 13, dans laquelle ladite résine synthétique est une résine à base de polyéthylène.

15. Formulation de polymère à retard de flamme selon la revendication 13, dans laquelle lesdites particules d'ATH ont un d₅₀ se situant dans la plage de 0,5 à 2,5 µm.

16. Formulation de polymère à retard de flamme selon la revendication 13, dans laquelle r₅₀ se situe dans la plage de 0,2 à 0,3 µm, Vₘₐₓ se situe dans la plage de 410 à 450 mm³/g, la surface spécifique BET se situe dans la plage de 3,5 à 5,5 m²/g, l'absorption d'huile se situe dans la plage de 23 % à 30 %, et d₅₀ se situe dans la plage de 1,3 à 2,5 µm.

17. Formulation de polymère à retard de flamme selon la revendication 15, dans laquelle l'absorption d'huile desdites particules d'ATH se situe dans la plage de 1 à 35 %.

18. Formulation de polymère à retard de flamme selon l'une quelconque des revendications 12 ou 16 - 17, dans laquelle ladite formulation de polymère à retard de flamme contient au moins un additif supplémentaire choisi parmi les auxiliaires d'extrusion ; les agents de couplage ; les colorants ; les pigments ; les charges ; les agents gonflants ; les désodorisants ; les agents de stabilisation thermique ; les anti-oxydants ; les agents antistatiques ; les agents de renforcement ; les piégeurs ou désactivateurs de métaux ; les modificateurs de la résistance au choc ; les auxiliaires de traitement ; les auxiliaires de démoulage ; les lubrifiants ; les agents antiadhérents ; les autres retardateurs de flamme ; les stabilisants vis-à-vis du rayonnement UV ; les plastifiants ; et les auxiliaires d'écoulement.

19. Article moulé ou extrudé formé à partir de la formulation de polymère à retard de flamme selon la revendication 18.
